# FASCICULE DE BREVET EUROPEEN

(11) **EP 2 753 942 B1**
(45) Date de publication et mention de la délivrance du brevet: **16.03.2016**
(21) Numéro de dépôt: 12759661.7
(22) Date de dépôt: 16.08.2012
(51) Int. Cl.: G01R 1/20, G01R 19/00, G01R 1/28, H01C 3/02, G01R 21/06

(54) **DISPOSITIF DE MESURE COMPORTANT UN SHUNT ET UN COMPTEUR ÉLECTRIQUE COMPORTANT UN TEL DISPOSITIF DE MESURE**
MESSVORRICHTUNG MIT EINEM SHUNT UND ELEKTRISCHER ZÄHLER MIT EINER SOLCHEN MESSVORRICHTUNG
MEASURING DEVICE COMPRISING A SHUNT AND AN ELECTRIC COUNTER COMPRISING SUCH A MEASURING DEVICE

(30) Priorité: 07.09.2011 FR 1157908
(43) Date de publication de la demande: 16.07.2014
(73) Titulaire: Sagemcom Energy & Telecom SAS, 92500 Rueil-Malmaison (FR)
(72) Inventeur: WEBER, Patrick, F-92500 Rueil-Malmaison (FR)
(74) Mandataire: Lavialle, Bruno François Stéphane
(86) Numéro de dépôt international: PCT/EP2012/066047
(87) Numéro de publication internationale: WO 2013/034418

(56) Documents cités:
- EP-A1- 0 030 186
- EP-A1- 0 848 258
- DE-A1- 10 258 115
- DE-A1-102006 034 579
- DE-B- 1 216 981
- FR-A1- 2 879 751
- US-A1- 2004 056 661
- US-A1- 2011 204 889
- KAWABATA S ET AL: "Measurement of AC current distributions in HTS tapes exposed to an external AC magnetic field by a compensated pickup coil array", IEEE TRANSACTIONS ON APPLIED SUPERCONDUCTIVITY, IEEE SERVICE CENTER, LOS ALAMITOS, CA, US, vol. 13, no. 2, 1 juin 2003 (2003-06-01), pages 3655-3658, XP011098501, ISSN: 1051-8223, DOI: 10.1109/TASC.2003.812423

## Description

L'invention concerne un dispositif de mesure comportant un shunt et possédant une première et une deuxième bornes entre lesquelles une tension représentative d'un courant traversant le shunt peut être mesurée. L'invention concerne également un compteur électrique comportant un tel dispositif de mesure.

### ARRIERE PLAN TECHNOLOGIQUE DE L'INVENTION

On connaît des dispositifs de mesure de courant comportant un shunt. Ces dispositifs mesurent entre deux bornes du shunt une tension à partir de laquelle il est possible de déterminer la valeur du courant traversant le shunt, le tronçon du shunt situé entre les deux bornes ayant une résistance connue voire calibrée.

Toutefois, lorsqu'un shunt est soumis à un champ magnétique alternatif externe, ledit champ magnétique peut induire une tension parasite dans le shunt qui vient alors se superposer à la tension couramment mesurée. De tels champs magnétiques alternatifs externes peuvent être naturels ou d'origine électromagnétiques par exemple dus à la présence dans l'environnement du shunt de circuits ou équipements électriques tels que des moteurs ou des conducteurs.

Cette tension parasite rend la mesure bien moins précise ce qui est particulièrement préjudiciable dans des équipements commerciaux de mesure tels que des compteurs de distribution électrique.

Il est connu de la demande de brevet FR 7 929 222 (EP-A0030186) un dispositif de compensation d'une telle tension parasite. Le dispositif de compensation est associé au shunt de manière à être soumis au même champ magnétique alternatif externe que celui-ci. Le dispositif de compensation consiste en une pièce métallique rapportée sur le shunt qui est dimensionnée et ajustée de telle sorte que la tension induite dans cette pièce métallique par le champ magnétique alternatif externe est sensiblement égale et en opposition à la tension d'erreur induite par ce même champ magnétique dans le shunt.

Ainsi la tension mesurée est égale à la somme de la tension représentative du courant traversant le shunt, de la tension d'erreur induite dans le shunt et de la tension induite dans le dispositif de compensation de sorte que la tension mesurée soit relativement représentative du courant traversant le shunt et ce quel que soit le champ magnétique alternatif externe auquel le shunt est soumis.

Le document US 2004/056661 A1 divulgue un dispositif de mesure comportant un shunt dont les câblages de liaison à un amplificateur forment des boucles.

Les documents DE 12 16 981, US 2011/204889, FR 2 879 751 et EP 0 848 258 divulguent également des dispositifs de mesure de type shunt.

### OBJET DE L'INVENTION

L'objectif de l'invention est de proposer un dispositif de mesure comportant un shunt et un organe de compensation plus perfectionné que ceux de l'art antérieur ainsi qu'un compteur électrique comportant un tel dispositif de mesure.

### BREVE DESCRIPTION DE L'INVENTION

A cet effet, on propose un dispositif de mesure comportant un shunt, le dispositif possédant une première et une deuxième bornes entre lesquelles une tension représentative d'un courant traversant le shunt peut être mesurée, le dispositif de mesure comportant en outre un organe de compensation connecté entre les bornes du dispositif et des bornes du shunt de sorte que lorsque le shunt est soumis à un champ magnétique alternatif externe, l'organe de compensation est également soumis à ce champ magnétique alternatif externe et qu'une tension induite dans l'organe de compensation du fait du champ magnétique alternatif externe est sensiblement égale et en opposition à une tension d'erreur induite dans le shunt du fait de ce même champ magnétique alternatif externe.

Selon l'invention, l'organe de compensation est porté par une carte électronique associée au shunt et comporte au moins une piste électriquement conductrice qui comporte, pour former au moins une boucle inductive, des portions imprimées sur une première face de la carte électronique en contact avec le shunt et des portions imprimées sur une deuxième face de la carte électronique opposée à la première face de la carte électronique.

La boucle inductive de l'organe de compensation subissant les mêmes perturbations magnétiques que le shunt induit une tension qui s'oppose à la tension d'erreur induite dans le shunt de sorte que la tension mesurée entre la première borne et la deuxième borne du dispositif de mesure soit relativement représentative du courant traversant le shunt et ce quel que soit le champ magnétique alternatif externe.

Grâce à la piste électriquement conductrice, l'organe de compensation est soumis aux mêmes perturbations que le shunt sans qu'il soit nécessaire de le disposer directement sur le shunt. Le dispositif de mesure selon l'invention s'avère donc très simple à fabriquer pour un coût moins élevé que les dispositifs de l'art antérieur. En outre, la piste électriquement conductrice étant aménagée sur la carte, la boucle inductive peut être réalisée au moyen de techniques classiques en matière de fabrication de circuit imprimé, techniques permettant une reproductibilité élevée.

L'invention concerne également un compteur électrique comportant un tel dispositif de mesure.

L'invention sera mieux comprise à la lumière de la description qui suit de modes de réalisation particuliers non limitatifs de l'invention.

### BREVE DESCRIPTION DES DESSINS

Il sera fait référence aux dessins ci-joints, parmi lesquels :
- la figure 1 est une vue en perspective schématique d'un premier mode de réalisation d'un dispositif de mesure selon l'invention ;
- la figure 2 est une vue schématique en perspective d'un deuxième mode de réalisation d'un dispositif de mesure selon l'invention, le shunt du dispositif de mesure n'étant pas représenté ;
- la figure 3 est une vue schématique en perspective du dispositif de mesure illustré à la figure 2, le shunt du dispositif de mesure étant représenté ;
- la figure 4 est une vue schématique en perspective du dispositif de mesure illustré à la figure 2, vu de côté ;
- la figure 5 est une vue schématique en perspective du dispositif de mesure illustré à la figure 2, vu de dessus ;
- la figure 6 est une vue schématique en perspective d'un troisième mode de réalisation d'un dispositif de mesure selon l'invention, le shunt du dispositif de mesure n'étant pas représenté.

### DESCRIPTION DETAILLEE DE L'INVENTION

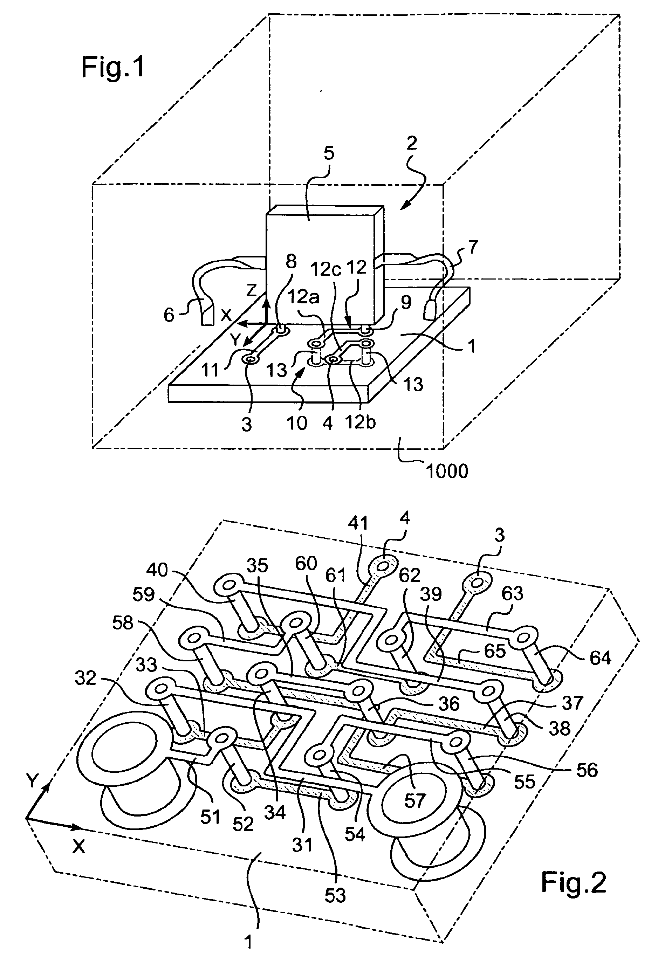

En référence à la figure 1, le dispositif de mesure comprend une carte électronique 1 ayant une première face qui porte ici un shunt 2 et est pourvue d'une première borne 3 et d'une deuxième borne 4.

Le shunt 2 comprend ici une pièce métallique 5, conformée en un parallélépipède rectangle, ayant une première face et une deuxième face qui est perpendiculaire à la première face et qui est pourvue d'une première borne 8 et d'une deuxième borne 9 disposées chacune à une extrémité de la deuxième face. Le shunt 2 comporte un premier connecteur 6 brasé sur une troisième face du shunt 2 de sorte à être disposé sensiblement dans un même plan que la première borne 8 de la pièce métallique 5, la troisième face étant perpendiculaire à la première face et la deuxième face. Le shunt 2 comporte en outre un deuxième connecteur 7 brasé sur une quatrième face du shunt 2 de sorte à être disposé sensiblement dans un même plan que la deuxième borne 9 de la pièce métallique 5, la quatrième face étant parallèle à la troisième face.

La deuxième face de la pièce métallique 5 est en regard de la première face de la carte électronique 1 de telle manière que la première borne 8 et la deuxième borne 9 de la pièce métallique 5 soient connectées à la carte électronique 1. Dans cette configuration, la pièce métallique 5 s'étend sensiblement à la verticale de la carte électronique 1 selon un premier axe Z, une première arête commune à la première et à la deuxième face de la pièce métallique 5 définissant une deuxième direction X, une deuxième arête de la deuxième face perpendiculaire à la première arête définissant une troisième direction Y.

Le dispositif de mesure comporte en outre un organe de compensation, généralement désigné en 10, monté ici entre la première borne 8 et la deuxième borne 9 de la pièce métallique 5 et la première borne 3 et la deuxième borne 4 du dispositif de mesure de telle sorte que, lorsque le shunt 2 est soumis à un champ magnétique alternatif externe, l'organe de compensation 10 soit également soumis à ce champ magnétique alternatif externe afin qu'une tension induite dans l'organe de compensation 10 du fait du champ magnétique alternatif externe soit sensiblement égale et en opposition à une tension d'erreur induite dans le shunt 2 du fait de ce même champ magnétique alternatif externe.

Ainsi, de façon connue en soi, par exemple lorsqu'un compteur électrique 1000 comporte le dispositif de mesure, pour déterminer la valeur d'un courant traversant un élément dudit compteur électrique 1000, le shunt 2 est branché en série avec ledit élément grâce au premier connecteur 6 et au deuxième connecteur 7 de la pièce métallique 5.

En absence de perturbations magnétiques, le courant circulant dans l'élément entre et sort de la pièce métallique 5 et provoque l'apparition d'une tension représentative du courant traversant le shunt 2, soit du courant circulant dans l'élément, entre la première borne 8 et la deuxième borne 9 de la pièce métallique 5. La tension entre la première borne 3 et la deuxième borne 4 du dispositif de mesure est alors sensiblement identique à la tension entre la première borne 8 et la deuxième borne 9 de la pièce métallique 5 et est relativement représentative du courant traversant le shunt 2. Connaissant la résistance du shunt 2, le courant traversant le shunt 2 peut être calculé à partir de ladite tension par application de la loi d'Ohm.

En cas de perturbations magnétiques, la tension entre la première borne 8 et la deuxième borne 9 de la pièce métallique 5 est la somme de la tension représentative du courant circulant dans le shunt 2 et d'une tension d'erreur induite dans le shunt 2 du fait des perturbations magnétiques. Entre la première borne 3 et la deuxième borne 4 du dispositif de mesure, il est ainsi mesuré la somme de la tension représentative du courant traversant le shunt 2, de la tension d'erreur induite dans le shunt 2 et de la tension induite dans l'organe de compensation 10. La tension entre la première borne 3 et la deuxième borne 4 du dispositif de mesure n'est alors plus identique à la tension entre la première borne 8 et la deuxième borne 9 de la pièce métallique 5 mais est relativement représentative du courant traversant le shunt, l'organe de compensation 10 permettant d'annuler la tension d'erreur induite dans le shunt 2.

Selon un premier mode de réalisation, l'organe de compensation 10 comporte ici une première piste électrique conductrice 11 qui est formée sur la carte électronique 1, et qui relie directement la première borne 8 de la pièce métallique 5 à la première borne 3 du dispositif de mesure. L'organe de compensation 10 comporte en outre une deuxième piste électrique conductrice 12 qui est formée sur la carte électronique 1 et qui relie la deuxième borne 9 de la pièce métallique 5 et la deuxième borne 4 du dispositif.

Selon l'invention, la deuxième piste 12 est ici agencée dans la carte électronique 1 pour former une boucle inductive. De préférence, la deuxième piste 12 est agencée pour former une boucle inductive dans un plan sensiblement parallèle à la première face de la pièce métallique 5 de sorte qu'en cas de perturbations magnétiques ladite boucle inductive forme une surface d'induction qui soit sensiblement parallèle à une surface d'induction formée dans la pièce métallique 5 et qui présente une inductance sensiblement égale et opposée à celle de la surface d'induction formée dans la pièce métallique 5. Ainsi, en cas de perturbations magnétiques, une tension induite dans l'organe de compensation 10 du fait de la boucle inductive sera bien sensiblement égale et en opposition à la tension d'erreur induite dans la pièce métallique 5.

De façon privilégiée, la deuxième piste 12 comporte des portions imprimées sur la première face de la carte électronique 1 et des portions imprimées sur une deuxième face de la carte électronique 1 qui est opposée à la première face de celle-ci. Les portions imprimées sur la première face de la carte électronique 1 sont connectées aux portions imprimées sur la deuxième face de la carte électronique 1 par des organes de liaison tels que des chemises métalliques 13 équipant des trous ménagés entre la première face et la deuxième face de la carte électronique 1 (on parle également de trous métallisés). La deuxième piste 12 est agencée de sorte qu'une portion imprimée sur la première face de la carte électronique 1 croise une portion imprimée sur la deuxième face de la carte électronique 1 afin de former sensiblement une boucle.

Selon un exemple d'agencement de la deuxième piste 12, la deuxième piste 12 comprend :
- une première portion 12a imprimée sur la première face de la carte électronique 1 qui connecte la deuxième borne 9 de la pièce métallique 5 à une extrémité d'une première chemise métallique, la première portion étant conformée en coude dont une partie est connectée à la deuxième borne 9 et s'étend parallèlement au deuxième axe X et l'autre partie est connectée à la première chemise métallique et s'étend parallèlement au troisième axe Y ;
- une deuxième portion 12b imprimée sur la deuxième face de la carte électronique 1 qui connecte l'autre extrémité de la première chemise métallique à une extrémité d'une deuxième chemise métallique, la deuxième portion s'étendant parallèlement au deuxième axe X sans croiser la première portion ;
- une troisième portion 12c imprimée sur la première face de la carte électronique 1 qui connecte l'autre extrémité de la deuxième chemise métallique à la deuxième borne 4 du dispositif de mesure, la troisième portion étant conformée en coude dont une partie est connectée à la deuxième chemise et s'étend parallèlement au deuxième axe X en regard de la deuxième portion et l'autre partie est connectée à la deuxième borne 4 du dispositif de mesure et s'étend parallèlement au troisième axe Y dans un même sens que la deuxième partie de la première portion.

En référence aux figures 2 à 5, un deuxième mode de réalisation va être à présent décrit. Les éléments identiques ou similaires à ceux du premier mode de réalisation illustré à la figure 1 conservent la même numérotation.

Dans ce deuxième mode de réalisation, l'organe de compensation 10 comporte une première piste électrique conductrice 21 qui est formée sur la carte électronique 1 et qui est agencée entre la première borne 8 de la pièce métallique 5 et la deuxième borne 4 du dispositif de mesure. L'organe de compensation 10 comporte en outre une deuxième piste électrique conductrice 22 qui est formée sur la carte électronique 1 et qui est agencée entre la deuxième borne 9 de la pièce métallique 5 et la première borne 3 du dispositif.

Selon l'invention, la première piste 21 est ici agencée sur la carte électronique 1 de sorte à former au moins une boucle inductive et la deuxième piste 22 est agencée sur la carte électronique de sorte à former au moins une autre boucle inductive.

De façon privilégiée, la première piste 21 comporte des portions imprimées sur la première face de la carte électronique 1 et des portions imprimées sur la deuxième face de la carte électronique 1. Les portions imprimées sur la première face de la carte électronique 1 sont connectées aux portions imprimées sur la deuxième face de la carte électronique 1 par des organes de liaison tels que des chemises métalliques. La deuxième piste 22 comporte des portions imprimées sur la première face de la carte électronique 1 et des portions imprimées sur la deuxième face de la carte électronique 1. Les portions imprimées sur la première face de la carte électronique 1 sont connectées aux portions imprimées sur la deuxième face de la carte électronique 1 par des organes de liaison tels que des chemises métalliques. Pour simplifier la compréhension des figures 2 à 5, les différentes portions imprimées sur la deuxième face de la carte électronique 1 sont illustrées hachurées. La première piste 21 est agencée de sorte que des portions de la première piste 21 imprimées sur la première face de la carte électronique 1 croisent des portions imprimées de la première piste 21 sur la deuxième face de la carte électronique 1 afin de former sensiblement au moins une boucle. De la même façon, la deuxième piste 22 est agencée de sorte que des portions de la deuxième piste 22 imprimées sur la première face de la carte électronique 1 croisent des portions de la deuxième piste 22 imprimées sur la deuxième face de la carte électronique 1 afin de former sensiblement au moins une autre boucle.

De préférence, la première piste 21 et la deuxième piste 22 sont agencées sur la carte électronique 1 pour former chacune au moins une boucle inductive dans un plan sensiblement parallèle à la première face de la pièce métallique 5 de sorte qu'en cas de perturbations magnétiques lesdites boucles inductives forment ensemble une surface d'induction totale sensiblement parallèle à la surface d'induction formée dans le shunt 2 et d'inductance sensiblement égale et opposée à celle de la surface d'induction formée dans la pièce métallique 5. Ainsi, une tension induite dans l'organe de compensation 10 du fait des boucles inductives sera bien sensiblement égale et en opposition à la tension d'erreur induite dans la pièce métallique 5 en cas de perturbations magnétiques.

De façon privilégiée, la première piste 21 et la deuxième piste 22 sont agencées sur la carte électronique 1 de sorte à être imbriquées l'une dans l'autre afin que, en cas de perturbations magnétiques, l'organe de compensation 10 forme uniquement une surface d'induction totale sensiblement parallèle à la surface d'induction formée dans le shunt 2 et d'inductance égale et opposée à celle de la surface d'induction formée dans la pièce métallique 5. A cet effet, des portions de la première piste 21 imprimées sur la première face de la carte électronique 1 croisent des portions de la deuxième piste 22 imprimées sur la deuxième face de la carte électronique 1 et/ou des portions de la première piste 21 imprimées sur la deuxième face de la carte électronique 1 croisent des portions de la deuxième piste 22 imprimées sur la première face de la carte électronique 1 pour former des boucles inductives formant ensemble une surface d'induction totale nulle dans d'autres plans que ceux parallèles à la première face de la pièce métallique 5.

De façon avantageuse, aucune surface totale d'induction n'est créée dans d'autres plans que ceux parallèles à la première face de la pièce métallique 5 ce qui pourrait sinon induire d'autres tensions dans l'organe de compensation 10 que la tension annulant la tension d'erreur. De cette façon, le dispositif de mesure estime encore plus précisément le courant traversant la pièce métallique 5.

Un exemple particulier d'agencement de l'organe de compensation 10 va être à présent décrit en référence à la figure 2.

La première piste 21 comporte :
- une première portion 31 imprimée sur la première face de la carte électronique 1 qui connecte la première borne 8 de la pièce métallique 5 à une extrémité d'une première chemise métallique 32, la première portion étant conformée en un double coude ayant une première et une deuxième partie d'extrémité qui s'étendent parallèlement au deuxième axe X et qui sont connectées, d'une part, à la première borne 8 de la pièce métallique 5 et à la première chemise métallique 32 respectivement et, d'autre part, toutes deux à une partie centrale de la première portion 31 s'étendant parallèlement au troisième axe Y ;
- une deuxième portion 33 imprimée sur la deuxième face de la carte électronique 1 qui connecte l'autre extrémité de la première chemise métallique 32 à une extrémité d'une deuxième chemise métallique 34, la deuxième portion étant conformée en coude ayant une première partie d'extrémité qui s'étend parallèlement au deuxième axe X en regard de la deuxième partie d'extrémité de la première portion 32 et qui est connectée à la première chemise métallique 32 et à une deuxième partie d'extrémité qui s'étend parallèlement au troisième axe Y et qui est connectée à la deuxième chemise métallique 34 ;
- une troisième portion 35 imprimée sur la première face de la carte électronique 1 qui connecte l'autre extrémité de la deuxième chemise métallique 34 à une extrémité d'une troisième chemise métallique 36, la troisième portion 35 s'étendant parallèlement au deuxième axe X ;
- une quatrième portion 37 imprimée sur la deuxième face de la carte électronique 1 qui connecte l'autre extrémité de la troisième chemise métallique 36 à une extrémité d'une quatrième chemise métallique 38, la quatrième portion 37 étant conformée en coude ayant une première partie d'extrémité qui s'étend parallèlement au troisième axe Y et qui est connectée à la troisième chemise métallique 36 et à une deuxième partie d'extrémité qui s'étend parallèlement au deuxième axe X et qui est connectée à la quatrième chemise métallique 38 ;
- une cinquième portion 39 imprimée sur la première face de la carte électronique 1 qui connecte l'autre extrémité de la quatrième chemise métallique 38 à une extrémité d'une cinquième chemise métallique 40, la cinquième portion 39 étant conformée en double coude ayant une première partie d'extrémité qui s'étend parallèlement au deuxième axe X en regard de la deuxième partie d'extrémité de la quatrième portion 37 et qui est connectée à la quatrième chemise métallique 38 et à une partie centrale qui s'étend parallèlement au troisième axe Y et qui est connectée à une deuxième partie d'extrémité qui s'étend parallèlement au deuxième axe X et qui est connectée à la cinquième chemise métallique 40 ;
- une sixième portion 41 imprimée sur la deuxième face de la carte électronique 1 qui connecte l'autre extrémité de la cinquième chemise métallique 40 à la deuxième borne 4 du dispositif de mesure, la sixième portion 41 étant conformée en coude ayant une première partie d'extrémité qui s'étend parallèlement au deuxième axe X en regard de la deuxième partie d'extrémité de la cinquième portion 39 et qui est connectée à la cinquième chemise métallique 40 et une deuxième partie d'extrémité qui s'étend parallèlement au troisième axe Y et qui est connectée à la deuxième borne 4 du dispositif de mesure.

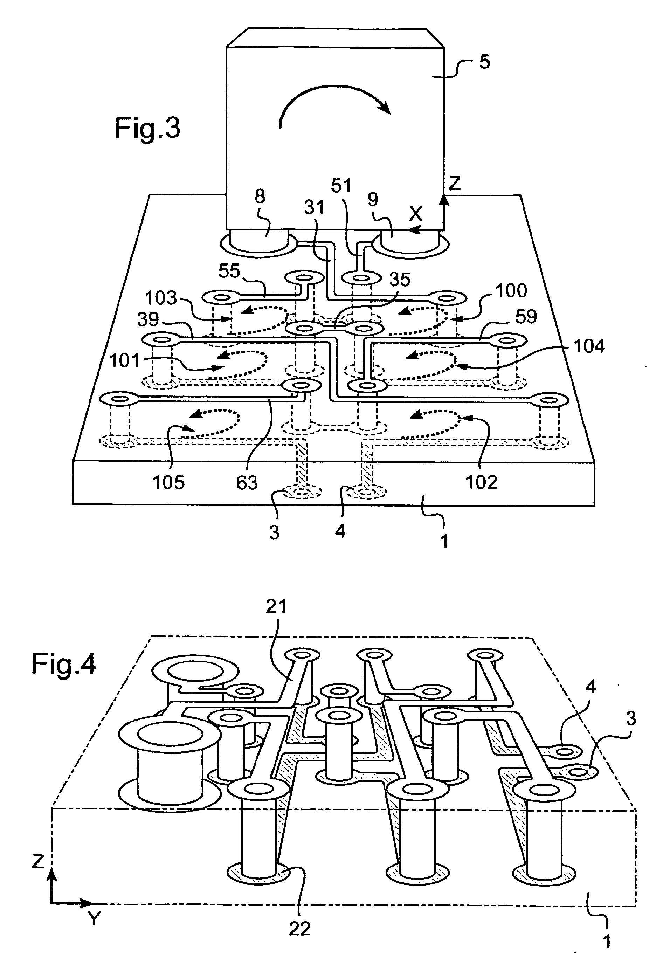

Ainsi agencée, la première piste 21 forme trois boucles inductives dans des plans sensiblement parallèles à la première face de la pièce métallique 5, comme cela est plus visible à la figure 3 :
- une première boucle 100 formée par la deuxième partie d'extrémité de la première portion 31, une première chemise 32 et la première partie d'extrémité de la deuxième portion 33 ;
- une deuxième boucle 101 formée par la deuxième partie d'extrémité de la quatrième portion 37, la quatrième chemise 38 et la première partie d'extrémité de la cinquième portion 39 ;
- une troisième boucle 102 formée par la deuxième partie d'extrémité de la cinquième portion 39, la cinquième chemise 40 et la première partie d'extrémité de la sixième portion 40.

La deuxième piste 22 comporte :
- une première portion 51 imprimée sur la première face de la carte électronique 1 qui connecte la deuxième borne 9 du shunt 2 à une extrémité d'une première chemise métallique 52, la première portion 51 étant conformée en coude ayant une première partie d'extrémité qui s'étend parallèlement au deuxième axe X et qui est connectée à la deuxième borne 9 du shunt 2 et une deuxième partie d'extrémité qui s'étend parallèlement au troisième axe Y et qui est connectée à la première chemise métallique 52 ;
- une deuxième portion 53 imprimée sur la deuxième face de la carte électronique 1 qui connecte l'autre extrémité de la première chemise métallique 52 à une extrémité d'une deuxième chemise métallique 54, la deuxième portion 53 s'étendant parallèlement au deuxième axe X en croisant la partie centrale de la première portion 31 de la première piste 21;
- une troisième portion 55 imprimée sur la première face de la carte électronique 1 qui connecte l'autre extrémité de la deuxième chemise métallique 54 à une extrémité d'une troisième chemise métallique 56, la troisième portion 55 étant conformée en coude ayant une première partie d'extrémité qui s'étend parallèlement au troisième axe Y et qui est connectée à la deuxième chemise métallique 54 et à une deuxième partie d'extrémité qui s'étend parallèlement au deuxième axe X et qui est connectée à la troisième chemise métallique 56 ;
- une quatrième portion 57 imprimée sur la deuxième face de la carte électronique 1 qui connecte l'autre extrémité de la troisième chemise métallique 56 à une extrémité d'une quatrième chemise métallique 58, la troisième portion 55 étant conformée en double coude ayant une première partie d'extrémité qui s'étend parallèlement au deuxième axe X en regard de la deuxième partie d'extrémité de la troisième portion 55 et qui est connectée à la troisième chemise métallique 56 et à une partie centrale qui s'étend parallèlement au troisième axe Y en croisant la troisième portion 35 de la première piste 21 et qui est connectée à une deuxième partie d'extrémité qui s'étend parallèlement au deuxième axe X et qui est connectée à la quatrième chemise métallique 58 ;
- une cinquième portion 59 imprimée sur la première face de la carte électronique 1 qui connecte l'autre extrémité de la quatrième chemise métallique 58 à une extrémité d'une cinquième chemise métallique 60, la cinquième portion 59 étant conformée en coude ayant une première partie d'extrémité qui s'étend parallèlement au deuxième axe X en regard de la deuxième partie d'extrémité de la quatrième portion 57 et qui est connectée à la quatrième chemise métallique 58 et à une deuxième partie d'extrémité qui s'étend parallèlement au troisième axe Y et qui est connectée à la cinquième chemise métallique 60;
- une sixième portion 61 imprimée sur la deuxième face de la carte électronique 1 qui connecte l'autre extrémité de la cinquième chemise métallique 60 à une extrémité d'une sixième chemise métallique 62, la sixième portion 61 s'étendant parallèlement au deuxième axe X en croisant la partie centrale de la cinquième portion 39 de la première piste 21;
- une septième portion 63 imprimée sur la première face de la carte électronique 1 qui connecte l'autre extrémité de la sixième chemise métallique 62 à une extrémité d'une septième chemise métallique 64, la septième portion 63 étant conformée en coude ayant une première partie d'extrémité qui s'étend parallèlement au troisième axe Y et qui est connectée à la sixième chemise métallique 62 et à une deuxième partie d'extrémité qui s'étend parallèlement au deuxième axe X et qui est connectée à la septième chemise métallique 64 ;
- une huitième portion 65 imprimée sur la deuxième face de la carte électronique 1 qui connecte l'autre extrémité de la septième chemise métallique 64 à la première borne 3 du dispositif de mesure, la huitième portion 65 étant conformée en coude ayant une première partie d'extrémité qui s'étend parallèlement au deuxième axe X en regard de la deuxième partie d'extrémité de la septième portion 63 et qui est connectée à la septième chemise métallique 64 et une deuxième partie d'extrémité qui s'étend parallèlement au troisième axe Y et qui est connectée à la première borne 3 du dispositif de mesure.

Ainsi agencée, la deuxième piste 22 forme trois boucles inductives dans des plans sensiblement parallèles à la première face de la pièce métallique 5, comme cela est plus visible à la figure 3 :
- une première boucle 103 formée par la deuxième partie d'extrémité de la troisième portion 55, la troisième chemise 56 et la première partie d'extrémité de la quatrième portion 57 ;
- une deuxième boucle 104 formée par la deuxième partie d'extrémité de la quatrième portion 57, la quatrième chemise 58 et la première partie d'extrémité de la cinquième portion 59 ;
- une troisième boucle 105 formée par la deuxième partie d'extrémité de la septième portion 63, la septième chemise 64 et la première partie d'extrémité de la huitième portion 65.

La première piste 21 et la deuxième piste 22 sont agencées de sorte que chacune des six boucles formées soient sensiblement de même taille.

En référence à la figure 3, en cas de perturbations magnétiques les trois boucles inductives 100, 101, 102 de la première piste 21 et les trois boucles inductives 103, 104 et 105 de la deuxième piste 22 forment ensemble une surface d'induction totale (matérialisée par les différentes flèches en trait pointillé) sensiblement parallèle à la surface d'induction formée dans le shunt 2 (matérialisée par la flèche en trait plein) et d'inductance sensiblement égale et opposée à celle de la surface d'induction formée dans la pièce métallique 5. Ainsi, une tension induite dans l'organe de compensation 10 du fait des boucles inductives sera bien sensiblement égale et en opposition à la tension d'erreur induite dans la pièce métallique 5 en cas de perturbations magnétiques.

En référence à la figure 4, grâce à l'agencement des deux pistes 21, 22, aucune boucle inductive n'est formée dans un plan perpendiculaire à la première face de la pièce métallique 5 et à la deuxième face de la pièce métallique 5.

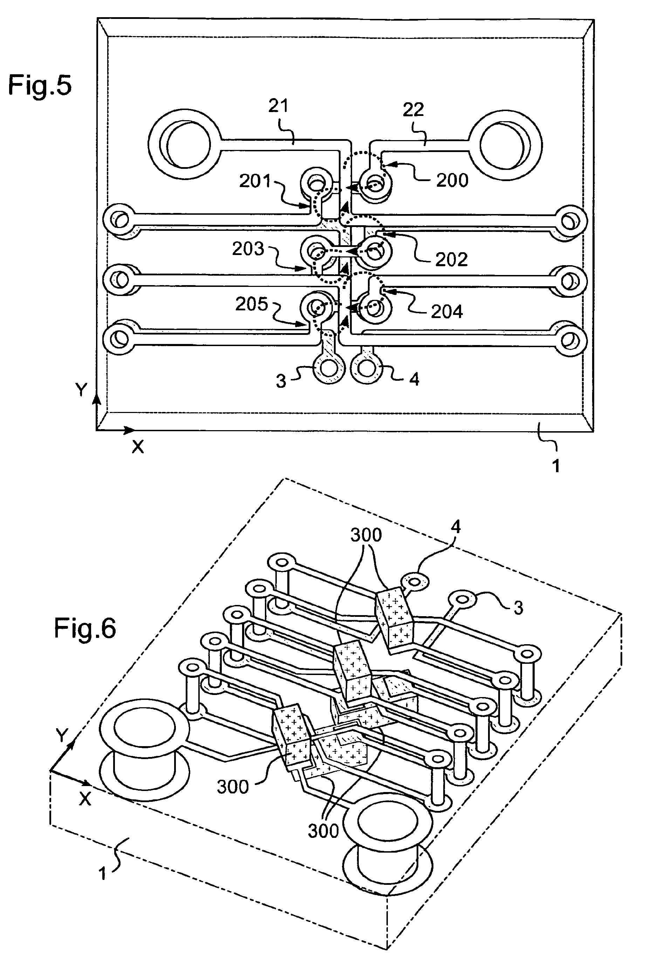

En référence à la figure 5, par le croisement de portions de la première piste 21 avec des portions de la deuxième piste 22, des boucles inductives sont formées dans des plans parallèles à la deuxième face de la pièce métallique 5 :
- une première boucle 200 formée entre la deuxième partie d'extrémité de la première portion 51 de la deuxième piste 22, la deuxième portion 53 de la deuxième piste 22 et la partie centrale de la première portion 31 de la première piste 21;
- une deuxième boucle 201 formée entre la partie centrale de la première portion 31 de la première piste 21, la deuxième portion 53 de la deuxième piste 22, la première partie d'extrémité de la troisième portion 55 de la deuxième piste 22 et la première partie d'extrémité de la quatrième portion 57 de la deuxième piste 22 ;
- une troisième boucle 202 formée entre la deuxième partie d'extrémité de la première portion 31 de la première piste 21, la deuxième partie de la deuxième portion 33 de la première piste 21, la troisième portion 35 de la première piste 21 et la partie centrale de la quatrième portion 57 de la deuxième piste 22 ;
- une quatrième boucle 203 formée entre la troisième portion 35 de la première piste 21, la première partie d'extrémité de la quatrième portion 37 de la première piste 21, la première partie d'extrémité de la cinquième portion 39 de la première piste 21 et la partie centrale de la quatrième portion 57 de la deuxième piste 22 ;
- une cinquième boucle 204 formée entre la deuxième partie d'extrémité de la quatrième portion 57 de la deuxième piste 22, la deuxième partie d'extrémité de la cinquième portion 59 de la deuxième piste 22, la sixième portion 61 de la deuxième piste 22 et la partie centrale de la cinquième portion 39 de la première piste 21 ;
- une sixième boucle 205 formée entre la première partie d'extrémité de la septième portion 63 de la deuxième piste 22, la sixième portion 61 de la deuxième piste 22 et la partie centrale de la cinquième portion 39 de la première piste 21.

La première piste 21 et la deuxième piste 22 sont agencées de sorte que chacune desdites six boucles formées soient sensiblement de même taille.

Les six boucles inductives 200, 201, 202, 203, 204 et 205 formées par l'imbrication de la première piste 21 et de la deuxième piste 22 forme chacune une surface d'induction (matérialisées par des flèches) sensiblement parallèle à la deuxième face de la pièce métallique 5 et d'inductance sensiblement égale en cas de perturbations magnétiques. Grâce à la symétrie des deux pistes 21, 22 trois boucles inductives 200, 202, 204 ont une inductance d'un signe et trois autres boucles inductives 201, 203, 205 ont une inductance du signe opposé de sorte que la surface d'induction totale formée par ces six boucles inductives soit sensiblement nulle.

Finalement, seules les boucles inductives formées dans des plans parallèles à la première face de la pièce métallique 5 forment une surface d'induction totale non nulle de sorte que la tension aux bornes du dispositif représente très précisément un courant traversant le shunt 2.

En référence à la figure 6, un troisième mode de réalisation va être à présent décrit. Les éléments communs avec le premier mode de réalisation illustré à la figure 1 conservent la même numérotation.

Dans le deuxième mode de réalisation, les boucles inductives étaient formées par croisement d'une portion d'une des pistes s'étendant sur une face de la carte électronique 1 avec une autre portion de ladite piste s'étendant sur l'autre face de la carte électronique 1.

Dans le troisième mode de réalisation, les boucles inductives sont formées par croisement d'une portion de la première piste 21 avec une portion de la deuxième piste 22 sur une même face de la carte électronique 1, une des portions étant décomposée en deux tronçons de sorte que l'autre des portions s'étende entre les deux tronçons, un composant de liaison 300 (illustré rempli de croix pour faciliter la compréhension de la figure) reliant les tronçons entre eux. Le composant de liaison est par exemple un dipôle linéaire passif électrique de résistance sensiblement nulle.

De préférence, et quel que soit le mode de réalisation retenu, sur les faces de la carte électronique 1 sur lesquelles sont imprimées les différentes pistes conductrices de l'organe de compensation 10, au moins une partie des surfaces desdites faces laissée libre par les pistes conductrices est en matériau conducteur. Selon un mode de réalisation privilégié, toutes les surfaces desdites faces laissées libres par les pistes conductrices sont en matériau conducteur. Bien entendu, on isole électriquement les pistes conductrices de l'organe de compensation 10 de ce matériau conducteur, par exemple en disposant un isolant entre les pistes conductrices et le matériau conducteur ou encore en aménageant un espace vide entre les pistes conductrices et le matériau conducteur par perforage des faces de la carte électronique.

En effet, les inventeurs ont constaté que le shunt 2 n'était pas ou peu perturbé par des perturbations magnétiques à hautes fréquences. En revanche, l'organe de compensation 10 peut, malgré tout, être perturbé par ces mêmes perturbations magnétiques. De façon remarquable, en entourant les pistes conductrices de surfaces conductrices, l'organe de compensation 10 est bien moins perturbé par lesdites perturbations magnétiques de sorte que la tension mesurée aux bornes du dispositif de mesure est bien plus représentative d'un courant traversant le shunt 2.

Bien entendu l'invention n'est pas limitée au mode de réalisation décrit et on peut y apporter des variantes de réalisation sans sortir du cadre de l'invention tel que défini par les revendications.

En particulier, l'organe de compensation 10 pourra avoir une toute autre configuration que celles précédemment écrites. Par exemple, l'organe de compensation pourra comporter une première piste électriquement conductrice et une deuxième piste électriquement conductrice qui sont imbriquées l'une dans l'autre sur la carte électronique 1 pour former ensemble au moins une autre boucle inductive de sorte qu'une tension induite dans l'organe de compensation du fait du champ magnétique alternatif externe est sensiblement égale et en opposition à une tension d'erreur induite dans le shunt du fait de ce même champ magnétique alternatif externe. L'organe de compensation pourra comporter une première piste électriquement conductrice et une deuxième piste électriquement conductrice qui forme chacune au moins une boucle inductive de sorte qu'une tension induite dans l'organe de compensation du fait du champ magnétique alternatif externe est sensiblement égale et en opposition à une tension d'erreur induite dans le shunt du fait de ce même champ magnétique alternatif externe, les deux pistes n'étant pas imbriquées. Le nombre de boucles inductives formées par chaque piste électriquement conductrice de l'organe de compensation pourra être différent de ceux décrits. En outre, le nombre de pistes électriquement conductrices de l'organe de compensation pourra être différent de celui indiqué.

Selon l'invention, l'organe de compensation devra être agencé de sorte qu'une tension induite dans l'organe de compensation par la ou les boucles inductives du fait du champ magnétique alternatif externe soit sensiblement égale et en opposition à une tension d'erreur induite dans le shunt du fait de ce même champ magnétique alternatif externe. A cet effet, il conviendra de jouer sur le nombre de boucles, l'orientation des boucles et la taille des boucles en fonction de la taille du shunt et de l'épaisseur du circuit imprimé. On retiendra que la surface totale d'induction formée par l'ensemble des boucles inductives dans un plan sensiblement parallèle à la surface d'induction formée dans le shunt, c'est-à-dire dans un plan sensiblement parallèle à la face du shunt traversé par le courant à mesurer, doit avoir une inductance sensiblement également et opposée à celle de la surface d'induction formée dans le shunt 2.

Bien qu'ici la carte électronique 1 porte le shunt 2, la carte électronique 1 pourra être seulement associée audit shunt 2 par exemple en étant disposée à proximité du shunt 2 tout en étant reliée électriquement au shunt 2 par des fils. L'organe de compensation 10 sera alors simplement connecté entre les bornes du dispositif et les bornes du shunt 2.

Le dispositif de mesure peut être utilisé pour d'autres applications que la détermination de la valeur d'un courant traversant un élément d'un compteur électrique par exemple le dispositif de mesure pourra être associé à une prise de courant.

## Revendications

1. Dispositif de mesure comportant un shunt (2), le dispositif possédant une première et une deuxième bornes (3, 4) entre lesquelles une tension représentative d'un courant traversant le shunt peut être mesurée, le dispositif de mesure comportant en outre un organe de compensation (10) connecté entre les bornes du dispositif et des bornes (8, 9) du shunt de sorte que lorsque le shunt est soumis à un champ magnétique alternatif externe, l'organe de compensation est également soumis à ce champ magnétique alternatif externe et qu'une tension induite dans l'organe de compensation du fait du champ magnétique alternatif externe est sensiblement égale et en opposition à une tension d'erreur induite dans le shunt du fait de ce même champ magnétique alternatif externe, le dispositif de mesure étant **caractérisé en ce que** l'organe de compensation est porté par une carte électronique (1) associée au shunt et comporte au moins une piste électriquement conductrice (12) qui comporte, pour former au moins une boucle inductive, des portions imprimées sur une première face de la carte électronique (1) en contact avec le shunt (2) et des portions imprimées sur une deuxième face de la carte électronique opposée à la première face de la carte électronique.

2. Dispositif de mesure selon la revendication 1, dans lequel la piste (12) est agencée pour former au moins une boucle inductive dans un plan sensiblement parallèle à une face du shunt traversée par le courant, ladite boucle inductive formant une surface d'induction qui est sensiblement parallèle à une surface d'induction formée dans le shunt et qui présente une inductance sensiblement égale et opposée à celle de la surface d'induction formée dans le shunt lorsque le shunt est soumis à un champ magnétique alternatif externe.

3. Dispositif de mesure selon la revendication 1, dans lequel, la piste étant agencée de sorte qu'au moins une portion imprimée sur la première face de la carte électronique croise une portion imprimée sur la deuxième face de la carte électronique afin de former sensiblement une boucle.

4. Dispositif de mesure selon la revendication 1, dans lequel l'organe de compensation (10) comporte une première piste (21) électriquement conductrice qui est formée sur la carte électronique (1) et qui est agencée pour former au moins une boucle inductive et une deuxième piste électriquement conductrice (22) qui est formée sur la carte électronique et qui agencée pour former au moins une autre boucle inductive.

5. Dispositif de mesure selon la revendication 4, dans lequel la première piste (21) et la deuxième piste (22) sont agencées pour former chacune au moins une boucle inductive (100, 101, 102, 103, 104, 105) dans un plan sensiblement parallèle à une face du shunt (2) traversée par le courant, lesdites boucles inductives formant ensemble une surface d'induction totale qui est sensiblement parallèle à une surface d'induction formée dans le shunt et qui présente une inductance sensiblement égale et opposée à celle de la surface d'induction formée dans le shunt lorsque le shunt est soumis à un champ magnétique alternatif externe.

6. Dispositif de mesure selon la revendication 4, dans lequel la première piste (21) et la deuxième piste (22) sont imbriquées l'une dans l'autre de sorte que l'organe de compensation (10) forme uniquement une surface d'induction totale sensiblement parallèle à la surface d'induction formée dans le shunt (2) et d'inductance égale et opposée à celle de la surface d'induction formée dans le shunt lorsque le shunt est soumis à un champ magnétique alternatif externe.

7. Dispositif de mesure selon la revendication 6, dans lequel la première piste (21) comporte des portions imprimées (31, 35, 39) sur la première face de la carte électronique (1) et des portions imprimées (33, 37, 41) sur la deuxième face de la carte électronique et la deuxième piste (22) comporte des portions imprimées (51, 55, 59, 63) sur la première face de la carte électronique et des portions imprimées (53, 57, 61, 65) sur la deuxième face de la carte électronique, les deux pistes étant agencées de sorte qu'au moins une portion de la première piste (31, 35, 39) imprimée sur la première face de la carte électronique croise une portion de la deuxième piste (53, 57, 61) imprimée sur la deuxième face de la carte électronique et/ou au moins une portion de la première piste imprimée sur la deuxième face de la carte électronique croise une portion de la deuxième piste imprimée sur la première face de la carte électronique pour former des boucles inductives formant une surface d'induction totale nulle dans d'autres plans que ceux parallèles à la face du shunt traversée par le courant.

8. Dispositif de mesure selon la revendication 1, dans lequel la piste (12) est agencée de sorte qu'au moins une portion imprimée sur une des faces de la carte électronique croise une portion imprimée sur la même face de la carte électronique afin de former sensiblement une boucle, une desdites portions étant décomposée en deux tronçons de sorte que l'autre des portions s'étende entre les deux tronçons, un composant de liaison (300) reliant les tronçons entre eux.

9. Dispositif de mesure selon la revendication 8, dans lequel le composant de liaison (300) est un dipôle linéaire passif électrique de résistance sensiblement nulle.

10. Dispositif de mesure selon la revendication 1, dans lequel un volume de la carte électronique (1) non occupé par l'organe de compensation (10) est comblé par un matériau isolant.

11. Dispositif de mesure selon la revendication 1, dans lequel au moins une partie des surfaces de la carte électronique (1) sur lesquelles est formée la piste conductrice (12) est en matériau conducteur, la piste conductrice étant isolée électriquement du matériau conducteur.

12. Compteur électrique comportant un dispositif de mesure selon l'une des revendications précédentes.

## Patentansprüche

1. Messvorrichtung, umfassend einen Shunt (2), wobei die Vorrichtung eine erste und eine zweite Anschlussklemme (3, 4) hat, zwischen denen eine Spannung gemessen werden kann, die repräsentativ für einen durch den Shunt fließenden Strom ist, wobei die Messvorrichtung ferner ein Kompensationsorgan (10) umfasst, das zwischen den Anschlussklemmen der Vorrichtung und Anschlussklemmen (8, 9) des Shunts derart angeschlossen ist, dass, wenn der Shunt einem äußeren magnetischen Wechselfeld ausgesetzt wird, das Kompensationsorgan ebenso diesem äußeren magnetischen Wechselfeld ausgesetzt wird und dass eine in dem Kompensationsorgan aufgrund des äußeren magnetischen Wechselfeldes induzierte Spannung im Wesentlichen gleich und entgegengesetzt zu einer Fehlerspannung ist, die in dem Shunt aufgrund desselben äußeren magnetischen Wechselfeldes induziert wird, wobei die Messvorrichtung **dadurch gekennzeichnet ist, dass** das Kompensationsorgan von einer Leiterplatte (1) getragen wird, die mit dem Shunt verbunden ist und mindestens eine elektrisch leitende Bahn (12) umfasst, die zum Bilden mindestens einer Induktionsschleife gedruckte Abschnitte auf einer ersten Fläche der Leiterplatte (1) umfasst, die mit dem Shunt (2) in Kontakt stehen, sowie gedruckte Abschnitte auf einer zweiten Fläche der Leiterplatte, die der ersten Fläche der Leiterplatte abgewandt ist.

2. Messvorrichtung nach Anspruch 1, wobei die Bahn (12) so ausgebildet ist, dass sie mindestens eine Induktionsschleife in einer Ebene bildet, die im Wesentlichen parallel zu einer von dem Strom durchflossenen Fläche des Shunts ist, wobei die genannte Induktionsschleife eine Induktionsoberfläche bildet, die im Wesentlichen parallel zu einer in dem Shunt gebildeten Induktionsoberfläche ist und die eine Induktivität aufweist, die im Wesentlichen gleich und entgegengesetzt zu der der in dem Shunt gebildeten Induktionsoberfläche ist, wenn der Shunt einem äußeren magnetischen Wechselfeld ausgesetzt wird.

3. Messvorrichtung nach Anspruch 1, wobei die Bahn derart ausgebildet ist, dass mindestens ein auf die erste Fläche der Leiterplatte gedruckter Abschnitt einen auf die zweite Fläche der Leiterplatte gedruckten Abschnitt kreuzt, um im Wesentlichen eine Schleife zu bilden.

4. Messvorrichtung nach Anspruch 1, wobei das Kompensationsorgan (10) eine erste elektrisch leitende Bahn (21) umfasst, die auf der Leiterplatte (1) gebildet und so ausgebildet ist, dass sie mindestens eine Induktionsschleife bildet, sowie eine zweite elektrisch leitende Bahn (22), die auf der Leiterplatte gebildet und so ausgebildet ist, dass sie mindestens eine weitere Induktionsschleife bildet.

5. Messvorrichtung nach Anspruch 4, wobei die erste Bahn (21) und die zweite Bahn (22) so ausgebildet sind, dass sie jeweils mindestens eine Induktionsschleife (100, 101, 102, 103, 104, 105) in einer Ebene bilden, die im Wesentlichen parallel zu einer von dem Strom durchflossenen Fläche des Shunts (2) ist, wobei die genannten Induktionsschleifen gemeinsam eine Gesamtinduktionsoberfläche bilden, die im Wesentlichen parallel zu einer in dem Shunt gebildeten Induktionsoberfläche ist und die eine Induktivität aufweist, die im Wesentlichen gleich und entgegengesetzt zu der der in dem Shunt gebildeten Induktionsoberfläche ist, wenn der Shunt einem äußeren magnetischen Wechselfeld ausgesetzt wird.

6. Messvorrichtung nach Anspruch 4, wobei die erste Bahn (21) und die zweite Bahn (22) ineinander derart verschachtelt sind, dass das Kompensationsorgan (10) allein eine Gesamtinduktionsoberfläche bildet, die im Wesentlichen parallel zu der in dem Shunt (2) gebildeten Induktionsoberfläche ist und eine Induktivität hat, die gleich und entgegengesetzt zu der der in dem Shunt gebildeten Induktionsoberfläche ist, wenn der Shunt einem äußeren magnetischen Wechselfeld ausgesetzt wird.

7. Messvorrichtung nach Anspruch 6, wobei die erste Bahn (21) gedruckte Abschnitte (31, 35, 39) auf der ersten Fläche der Leiterplatte (1) und gedruckte Abschnitte (33, 37, 41) auf der zweiten Fläche der Leiterplatte umfasst, und die zweite Bahn (22) gedruckte Abschnitte (51, 55, 59, 63) auf der ersten Fläche der Leiterplatte und gedruckte Abschnitte (53, 57, 61, 65) auf der zweiten Fläche der Leiterplatte umfasst, wobei die beiden Bahnen so ausgebildet sind, dass mindestens ein Abschnitt der ersten Bahn (31, 35, 39), der auf die erste Fläche der Leiterplatte gedruckt ist, einen Abschnitt der zweiten Bahn (53, 57, 61), der auf die zweite Fläche der Leiterplatte gedruckt ist, kreuzt und/oder mindestens ein Abschnitt der ersten Bahn, der auf die zweite Fläche der Leiterplatte gedruckt ist, einen Abschnitt der zweiten Bahn kreuzt, die auf die erste Fläche der Leiterplatte gedruckt ist, um Induktionsschleifen zu bilden, die eine Gesamtinduktionsoberfläche von Null in anderen Ebenen als denen bilden, die parallel zu der von dem Strom durchflossenen Fläche des Shunts sind.

8. Messvorrichtung nach Anspruch 1, wobei die Bahn (12) so ausgebildet ist, dass mindestens ein auf eine der Flächen der Leiterplatte gedruckter Abschnitt einen auf die gleiche Fläche der Leiterplatte gedruckten Abschnitt kreuzt, um im Wesentlichen eine Schleife zu bilden, wobei einer der genannten Abschnitte in zwei Teilabschnitte unterteilt ist, derart, dass sich der andere der Abschnitte zwischen den beiden Teilabschnitten erstreckt, wobei eine Verbindungskomponente (300) die Teilabschnitte miteinander verbindet.

9. Messvorrichtung nach Anspruch 8, wobei die Verbindungskomponente (300) ein elektrischer passiver linearer Dipol mit einem Widerstand von im Wesentlichen Null ist.

10. Messvorrichtung nach Anspruch 1, wobei ein Volumen der Leiterplatte (1), das nicht von dem Kompensationsorgan (10) eingenommen ist, durch ein Isoliermaterial aufgefüllt ist.

11. Messvorrichtung nach Anspruch 1, wobei mindestens ein Teil der Oberflächen der Leiterplatte (1), auf denen die leitende Bahn (12) gebildet ist, aus einem leitenden Material ist, wobei die leitende Bahn vom leitenden Material elektrisch isoliert ist.

12. Stromzähler, umfassend eine Messvorrichtung nach einem der vorhergehenden Ansprüche.

## Claims

1. A measurement device including a shunt (2), the device possessing first and second terminals (3, 4) between which a voltage representative of a current passing through the shunt can be measured, the measurement device further including a compensation member (10) connected between the terminals of the device and terminals (8, 9) of the shunt so that when the shunt is subjected to an external alternating magnetic field the compensation member is likewise subjected to said external alternating magnetic field and a voltage induced in the compensation member because of the external alternating magnetic field is substantially equal and in opposition to an error voltage induced in the shunt because of the same external alternating magnetic field, the measurement device being **characterized in that** the compensation member is carried by an electronic card (1) associated with the shunt and includes at least one electrically conductive track (12) that, in order to form at least one inductive loop, includes portions printed on a first face of the electronic card (1) in contact with the shunt (2) and portions printed on a second face of the electronic card opposite from the first face of the electronic card.

2. A measurement device according to claim 1, wherein the track (12) is arranged to form at least one inductive loop in a plane substantially parallel to a face of the shunt through which the current passes, said inductive loop forming an induction surface area that is substantially parallel to an induction surface area formed in the shunt and that presents induction substantially equal and opposite to the induction of the induction surface area formed in the shunt when the shunt is subjected to an external alternating magnetic field.

3. A measurement device according to claim 1, wherein the track is arranged in such a manner that at least one portion printed on the first face of the electronic card crosses a portion printed on the second face of the electronic card in order to form substantially a loop.

4. A measurement device according to claim 1, wherein the compensation member (10) includes a first electrically conductive track (21) that is formed on the electronic card (1) and that is arranged to form at least one inductive loop, and a second electrically conductive track (22) that is formed on the electronic card and that is arranged to form at least one other inductive loop.

5. A measurement device according to claim 4, wherein each of the first and second tracks (21 and 22) is arranged to form at least one inductive loop (100, 101, 102, 103, 104, 105) in a plane substantially parallel to a plane of the shunt (2) through which the current passes, said inductive loops together forming a total induction surface area that is substantially parallel to an induction surface area formed in the shunt and that presents induction substantially equal to and opposite to the induction of the induction surface area formed in the shunt when the shunt is subjected to an external alternating magnetic field.

6. A measurement device according to claim 4, wherein the first track (21) and the second track (22) are interleaved one in the other in such a manner that the compensation member (10) forms only one total induction surface area that is substantially parallel to the induction surface area formed in the shunt (2) and of induction equal and opposite to the induction of the induction surface area formed in the shunt when the shunt is subjected to an external alternating magnetic field.

7. A measurement device according to claim 6, wherein the first track (21) includes portions (31, 35, 39) printed on the first face of the electronic card (1) and portions (33, 37, 41) printed on the second face of the electronic card, and the second track (22) includes portions (51, 55, 59, 63) printed on the first face of the electronic card and portions (53, 57, 61, 65) printed on the second face of the electronic card, the two tracks being arranged in such a manner that at least one portion of the first track (31, 35, 39) printed on the first face of the electronic card crosses a portion of the second track (53, 57, 61) printed on the second face of the electronic card, and/or at least one portion of the first track printed on the second face of the electronic card crosses a portion of the second track printed on the first face of the electronic card in order to form inductive loops forming a total induction surface area of zero in planes other than those parallel to the face of the shunt through which the current passes.

8. A measurement device according to claim 1, wherein the track (12) is arranged in such a manner that at least one portion printed on one of the faces of the electronic card crosses a portion printed on the same face of the electronic card in order to form substantially a loop, one of said portions being subdivided into two segments such that the other one of the portions extends between the two segments, with a link component (300) interconnecting the segments.

9. A measurement device according to claim 8, wherein the link component (300) is a passive linear two-terminal electrical circuit of substantially zero resistance.

10. A measurement device according to claim 1, wherein a volume of the electronic card (1) that is not occupied by the compensation member (10) is filled in with an insulating material.

11. A measurement device according to claim 1, wherein at least one portion of the surfaces of the electronic card (1) on which the conductive track (12) is formed is made of conductive material, the conductive track being electrically insulated from the conductive material.

12. An electricity meter including a measurement device according to any preceding claim.
